# EUROPÄISCHE PATENTANMELDUNG

(11) **EP 3 664 269 A1**
(43) Veröffentlichungstag der Anmeldung: **10.06.2020**
(21) Anmeldenummer: 18211063.5
(22) Anmeldetag: 07.12.2018
(51) Int. Cl.: H02M 3/158, G01R 15/14, H01F 17/04, H02M 1/00

(54) **MESSSHUNT**

(71) Anmelder: Siemens Aktiengesellschaft, 80333 München (DE)
(72) Erfinder: Lorz, Roland, 91341 Röttenbach (DE)

(57) **Zusammenfassung**

Die Erfindung betrifft einen Messshunt (1). Der Messshunt (1) umfasst ein Widerstandselement (3) und einen magnetischen Kern (5). Das Widerstandselement (3) weist zwei Hauptkontakte (7,9) und einen zwischen den Hauptkontakten (7,9) verlaufenden Mittelabschnitt (11) zur Leitung eines elektrischen Stroms (11,12) zwischen den beiden Hauptkontakten (7,9) durch den Mittelabschnitt (11) auf. Der magnetische Kern (5) verläuft ringartig um den Mittelabschnitt (11) des Widerstandselements (3).

## Beschreibung

Die Erfindung betrifft einen Messshunt, insbesondere für Schaltungsanordnungen mit parallel geschalteten Halbbrücken elektronischer Schalter und Stromrichter mit derartigen Schaltungsanordnungen.

Parallelschaltungen von Halbbrücken elektronischer Schalter werden insbesondere in Stromrichtern verwendet, um eine ausreichende Stromrichterleistung zu erzielen. Bei derartigen Parallelschaltungen werden elektronische Schalter räumlich nahe benachbart angeordnet, wodurch die elektronischen Schalter gekoppelt werden. Zur Entkoppelung der elektronischen Schalter können Induktivitäten verwendet werden, auf die aus Kostengründen jedoch häufig verzichtet wird. Messshunts werden in Stromrichtern unter anderem zur Messung von Phasenströmen eingesetzt, beispielsweise für eine Drehzahlregelung von Motoren, die über Stromrichter angetrieben werden.

Der Erfindung liegt die Aufgabe zugrunde, einen Messshunt anzugeben, der insbesondere für Schaltungsanordnungen mit parallel geschalteten Halbbrücken elektronischer Schalter und Stromrichter mit derartigen Schaltungsanordnungen verbessert ist.

Die Aufgabe wird erfindungsgemäß durch einen Messshunt mit den Merkmalen des Anspruchs 1, eine Schaltungsanordnung mit den Merkmalen des Anspruchs 8 und einen Stromrichter mit den Merkmalen des Anspruchs 9 gelöst.

Vorteilhafte Ausgestaltungen der Erfindung sind Gegenstand der Unteransprüche.

Ein erfindungsgemäßer Messshunt umfasst ein Widerstandselement mit zwei Hauptkontakten und einem zwischen den Hauptkontakten verlaufenden Mittelabschnitt zur Leitung eines elektrischen Stroms zwischen den beiden Hauptkontakten durch den Mittelabschnitt. Ferner weist der Messshunt einen magnetischen Kern auf, der ringartig um den Mittelabschnitt des Widerstandselements verläuft.

Der um das Widerstandselement verlaufende magnetische Kern verleiht dem Messshunt eine Induktivität, die zur Entkoppelung elektronischer Schalter in parallelgeschalteten Halbbrücken verwendet werden kann. Ein erfindungsgemäßer Messshunt ermöglicht daher neben einer Strommessung auch die Entkopplung elektronischer Schalter in parallelgeschalteten Halbbrücken. Außerdem ermöglicht ein erfindungsgemäßer Messshunt durch die Filterwirkung seiner Induktivität eine Begrenzung von Unsymmetrien und Spannungssteilheiten an den Ausgängen parallelgeschalteter Halbbrücken. Dadurch wird die Funktionalität des Messshunt vorteilhaft erhöht.

Eine Ausgestaltung der Erfindung sieht zwei Hilfskontakte zum Abgreifen einer Messspannung vor, die zwischen zwei auf verschiedenen Seiten des magnetischen Kerns liegenden Messstellen des Widerstandselements abfällt. Diese Ausgestaltung der Erfindung ermöglicht eine Verbesserung der Messgenauigkeit des Messshunt durch eine Vierleitermessung, bei der ein durch das Widerstandselement fließender Strom über ein Messspannung gemessen wird, die an den Hilfskontakten abgegriffen wird.

Eine Weitergestaltung der vorgenannten Ausgestaltung der Erfindung sieht vor, dass einer der Hilfskontakte von einer der Messstellen durch den magnetischen Kern verläuft. Diese Weitergestaltung verhindert, dass die an den Hilfskontakten abgegriffene Messspannung eine Spannung enthält, die durch den magnetischen Kern induziert wird und das Messsignal verfälscht.

Eine weitere Ausgestaltung der Erfindung sieht vor, dass der Mittelabschnitt des Widerstandselements U-förmig ausgebildet ist. Dadurch kann der Messshunt in einfacher Weise mit den Hauptkontakten auf einem ebenen Schaltungsträger angeordnet werden.

Eine weitere Ausgestaltung der Erfindung sieht vor, dass der magnetische Kern aus zwei aneinandergefügten Kernteilen besteht. Diese Ausgestaltung der Erfindung ermöglicht eine einfache Montage des magnetischen Kerns um das Widerstandselement durch Zusammenfügen der beiden Kernteile.

Eine weitere Ausgestaltung der Erfindung sieht vor, dass der magnetische Kern von dem Widerstandselement durch einen Luftspalt beabstandet ist. Durch den Luftspalt kann vorteilhaft eine Induktivität des Messshunt beeinflusst werden.

Eine zu den beiden vorgenannten Ausgestaltungen alternative Ausgestaltung der Erfindung sieht vor, dass der magnetische Kern um den Mittelabschnitt des Widerstandselements spritzgegossen ist. Diese Ausgestaltung der Erfindung ermöglicht eine einfache serienmäßige Fertigung des Messshunt durch Spritzgießen des magnetischen Kerns.

Der magnetische Kern ist vorzugsweise aus einem Material mit einer hohen magnetischen Permeabilität, einer hohen Sättigungsmagnetisierung und/oder geringen frequenzabhängigen magnetischen Verlusten gefertigt. Beispielsweise ist der magnetische Kern aus Eisen oder einem ferrimagnetischen Material gefertigt. Wenn der magnetische Kern spritzgegossen wird, wird er beispielsweise aus einem Gemisch eines Trägermaterials, beispielsweise eines Kunststoffs, und eines magnetischen Materials, beispielsweise eines magnetischen Pulvers wie Eisenpulver oder eines ferrimagnetischen Pulvers, gefertigt.

Das Widerstandselement ist vorzugsweise aus einem Material gefertigt, das einen geringen spezifischen elektrischen Widerstand und eine geringe Temperaturabhängigkeit seines elektrischen Widerstands aufweist. Beispielsweise ist das Widerstandselement aus einer Kupfer-Nickel-Mangan-Legierung gefertigt.

Eine erfindungsgemäße Schaltungsanordnung weist wenigstens zwei zueinander parallel geschaltete Halbbrücken auf, in deren Brückenarmen jeweils wenigstens ein elektronischer Schalter angeordnet ist, wobei in dem Brückenzweig jeder Halbbrücke ein erfindungsgemäßer Messshunt angeordnet ist. Durch die Messshunts können einerseits die in den Brückenzweigen fließenden Ströme gemessen werden und andererseits werden die parallel geschalteten Halbbrücken entkoppelt, ohne weitere Bauelemente verwenden zu müssen. Außerdem wird durch die Filterwirkung des Messshunt eine Spannungssteilheit an dem Ausgang der Schaltungsanordnung begrenzt.

Ein erfindungsgemäßer Stromrichter weist wenigstens eine erfindungsgemäße Schaltungsanordnung parallel geschalteter Halbbrücken mit elektronischen Schaltern auf. Die Vorteile eines derartigen Stromrichters ergeben sich aus den oben genannten Vorteilen einer erfindungsgemäßen Schaltungsanordnung.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine erste perspektivische Darstellung eines Messshunt,
- FIG 2: eine zweite perspektivische Darstellung des in FIG 1 gezeigten Messshunt,
- Fig 3: eine Schaltungsanordnung mit zwei zueinander parallel geschalteten Halbbrücken elektronischer Schalter,
- FIG 4: einen Schaltplan eines Stromrichters.

Einander entsprechende Teile sind in den Figuren mit denselben Bezugszeichen versehen.

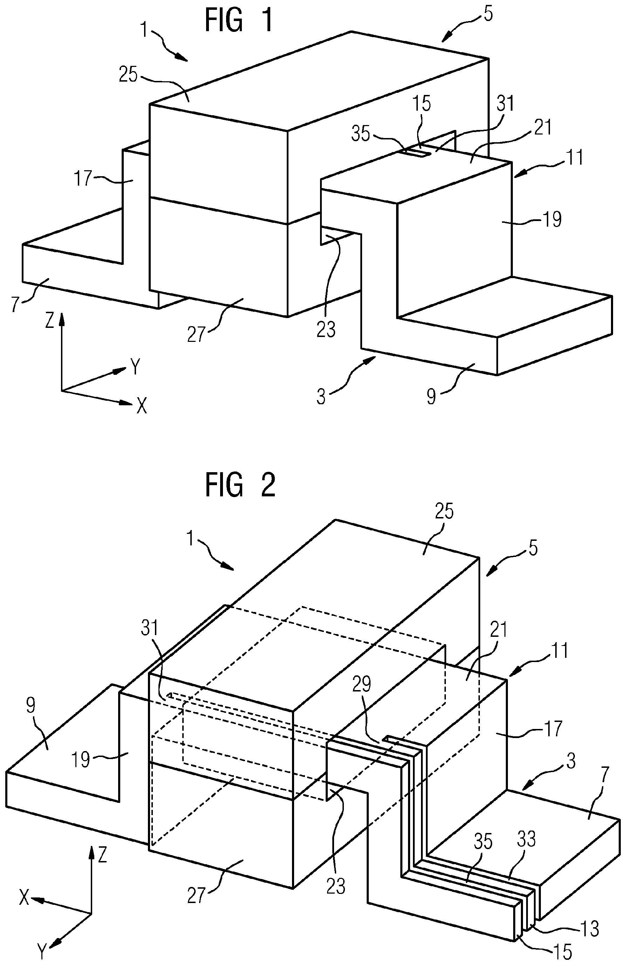

Die Figuren 1 und 2 zeigen zwei verschiedene perspektivische Darstellungen eines Ausführungsbeispiels eines erfindungsgemäßen Messshunt 1, wobei zur Verdeutlichung der dargestellten Perspektiven jeweils ein kartesisches Koordinatensystem mit Koordinaten X, Y, Z gezeichnet ist. Der Messshunt 1 weist ein Widerstandselement 3 und einen magnetischen Kern 5 auf.

Das Widerstandselement 3 weist zwei Hauptkontakte 7, 9, einen Mittelabschnitt 11 und zwei Hilfskontakte 13, 15 auf. Der Mittelabschnitt 11 verläuft zwischen den Hauptkontakten 7, 9. Der Mittelabschnitt 11 ist U-förmig mit zwei Schenkeln 17, 19 und einem zwischen den Schenkeln 17, 19 verlaufenden Zentralabschnitt 21 ausgebildet. Jeder Hauptkontakt 7, 9 ist von einem der Schenkel 17, 19 abgewinkelt, so dass die Hauptkontakte 7, 9 an einander gegenüberliegenden Seiten und voneinander weggerichtet von dem Mittelabschnitt 11 abstehen.

Der magnetische Kern 5 verläuft ringartig um den Zentralabschnitt 21 des Widerstandselements 3 und ist von dem Zentralabschnitt 21 durch einen Luftspalt 23 beabstandet. Der magnetische Kern 5 besteht aus zwei aneinandergefügten Kernteilen 25, 27, die jeweils U-förmig ausgebildet sind. Der magnetische Kern 5 hat die Form eines Quaders mit einer Öffnung, durch die der Zentralabschnitt 21 des Widerstandselements 3 verläuft.

Jeder Hilfskontakt 13, 15 verläuft von einer Messstelle 29, 31 in dem Zentralabschnitt 21 zu einem Ende des Widerstandselements 3 in dem Bereich eines ersten Hauptkontaktes 7. Dabei sind die beiden Messstellen 29, 31 auf voneinander verschiedenen Seiten des magnetischen Kerns 5 angeordnet. Ein erster Hilfskontakt 13 verläuft von einer ersten Messstelle 29 vollständig auf einer dem ersten Hauptkontakt 7 zugewandten Seite des magnetischen Kerns 5. Der zweite Hilfskontakt 15 verläuft von der zweiten Messstelle 31, die auf einer dem zweiten Hauptkontakt 9 zugewandten Seite des magnetischen Kerns 5 liegt, durch den magnetischen Kern 5 zu der dem ersten Hauptkontakt 7 zugewandten Seite des magnetischen Kerns 5.

Die Hilfskontakte 13, 15 des in den Figuren 1 und 2 gezeigten Ausführungsbeispiels eines Messshunt 1 werden durch zwei Schlitze 33, 35 in dem Widerstandselement 3 erzeugt, die jeweils durch einen Teilbereich des Zentralabschnitts 21 und einen ersten Schenkel 17 des Mittelabschnitts 11 zu dem Ende des Widerstandselements 3 in dem Bereich des ersten Hauptkontaktes 7 verlaufen. Die Schlitze 33, 35 trennen die beiden Hilfskontakte 13, 15 voneinander und von dem ersten Hauptkontakt 7, wobei ein erster Schlitz 33 den ersten Hilfskontakt 13 von dem ersten Hauptkontakt 7 trennt und der zweite Schlitz 35 die beiden Hilfskontakte 13, 15 voneinander trennt.

Das Widerstandselement 3 dient der Messung eines elektrischen Stroms, der zwischen den Hauptkontakten 7, 9 durch den Mittelabschnitt 3 fließt. Der elektrische Strom wird nach dem Prinzip einer Vierleitermessung über eine zwischen den beiden Messstellen 29, 31 anliegende elektrische Messspannung gemessen, die an den Hilfskontakten 13, 15 abgegriffen wird.

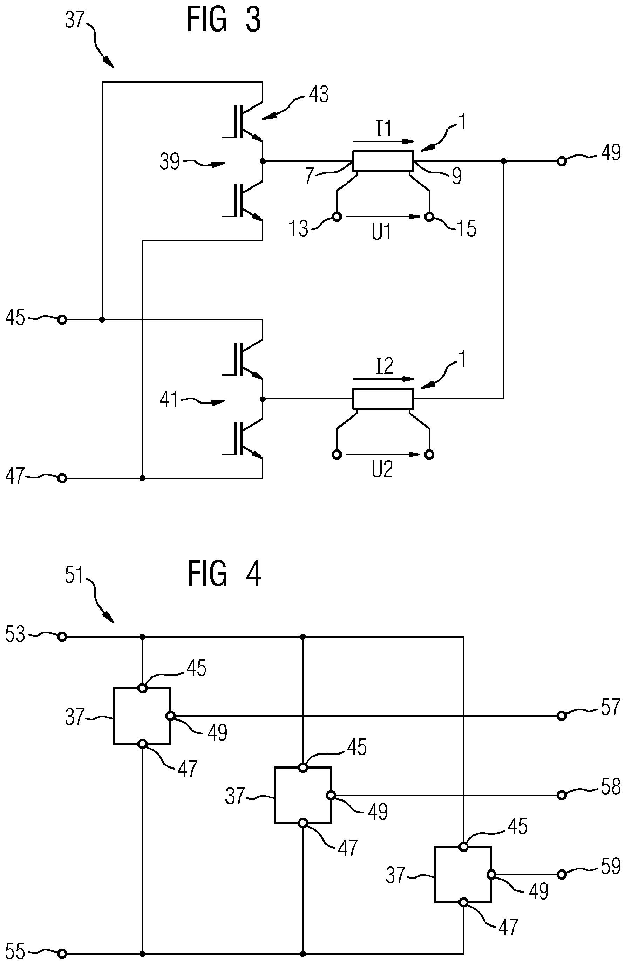

Der magnetische Kern 5 dient der Entkoppelung parallel geschalteter elektronischer Schalter 43 wie bei der in FIG 3 gezeigten Schaltungsanordnung 37.

In alternativen Ausführungsbeispielen des Messshunt 1 können die Hilfskontakte 13, 15 in anderer Weise als in dem in den Figuren 1 und 2 gezeigten Ausführungsbeispiel ausgeführt sein, beispielsweise jeweils als eine mit einer Messstelle 29, 31 verbundene separate elektrische Leitung. Wesentlich ist dabei jedoch, dass einer der beiden Hilfskontakte 13 oder 15 parallel zu einer Fließrichtung eines durch das Widerstandselement 3 fließenden elektrischen Stroms durch den magnetischen Kern 5 verläuft. Ferner kann der magnetische Kern 5 in anderer Weise ausgeführt sein als in dem in den Figuren 1 und 2 gezeigten Ausführungsbeispiel. Beispielsweise kann der magnetische Kern 5 um den Mittelabschnitt 11 des Widerstandselements 3 spritzgegossen werden, beispielsweise aus einem Gemisch eines Trägermaterials, beispielsweise eines Kunststoffs, und eines magnetischen Materials, beispielsweise eines magnetischen Pulvers.

FIG 3 zeigt einen Schaltplan eines Ausführungsbeispiels einer erfindungsgemäßen Schaltungsanordnung 37 mit zwei zueinander parallel geschalteten Halbbrücken 39, 41, in deren Brückenarmen jeweils ein elektronischer Schalter 43 angeordnet ist. In dem Brückenzweig jeder Halbbrücke 39, 41 ist ein wie in den Figuren 1 und 2 ausgebildeter Messshunt 1 angeordnet, mit dem ein in dem Brückenzweig und durch das Widerstandselement 3 des Messshunt 1 fließender elektrischer Strom I1, I2 über eine elektrische Messspannung U1, U2 gemessen wird, die an den Hilfskontakten 13, 15 des Messshunt 1 abgegriffen wird. Ein erster Brückenarm jeder Halbbrücke 39, 41 ist mit einem ersten Gleichspannungsanschluss 45 der Schaltungsanordnung 37 verbunden. Der zweite Brückenarm jeder Halbbrücke 39, 41 ist mit einem zweiten Gleichspannungsanschluss 47 der Schaltungsanordnung 37 verbunden. Die Messhunts 1 sind ausgangsseitig mit einem Wechselspannungsanschluss 49 der Schaltungsanordnung 37 verbunden. Die elektronischen Schalter 43 sind in dem in FIG 3 gezeigten Ausführungsbeispiel einer erfindungsgemäßen Schaltungsanordnung 37 Bipolartransistoren mit isolierter Gate-Elektrode (IGBT), können in anderen Ausführungsbeispielen jedoch auch andere Halbleiterschalter sein, beispielsweise Metall-Oxid-Halbleiter-Feldeffekttransistoren (MOSFET).

FIG 4 zeigt einen Schaltplan eines Ausführungsbeispiels eines erfindungsgemäßen Stromrichters 51. Der Stromrichter 51 weist zwei Stromrichtergleichspannungsanschlüsse 53, 55, drei Stromrichterwechselspannungsanschlüsse 57 bis 59 und drei jeweils wie in FIG 3 ausgebildete Schaltungsanordnungen 37 auf. Der erste Gleichspannungsanschluss 45 jeder Schaltungsanordnung 37 ist mit einem ersten Stromrichtergleichspannungsanschluss 53 verbunden. Der zweite Gleichspannungsanschluss 47 jeder Schaltungsanordnung 37 ist mit dem zweiten Stromrichtergleichspannungsanschluss 55 verbunden. Der Wechselspannungsanschluss 49 jeder Schaltungsanordnung 37 ist mit einem Stromrichterwechselspannungsanschluss 57 bis 59 verbunden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Messshunt (1), umfassend
- ein Widerstandselement (3) mit zwei Hauptkontakten (7,9) und einem zwischen den Hauptkontakten (7,9) verlaufenden Mittelabschnitt (11) zur Leitung eines elektrischen Stroms (I1,I2) zwischen den beiden Hauptkontakten (7,9) durch den Mittelabschnitt (11) und
- einen magnetischen Kern (5), der ringartig um den Mittelabschnitt (11) des Widerstandselements (3) verläuft.

2. Messshunt (1) nach Anspruch 1 mit zwei Hilfskontakten (13, 15) zum Abgreifen einer Messspannung (U1,U2), die zwischen zwei auf verschiedenen Seiten des magnetischen Kerns (5) liegenden Messstellen (29,31) des Widerstandselements (3) abfällt.

3. Messshunt (1) nach Anspruch 2, wobei einer der Hilfskontakte (13,15) von einer der Messstellen (29,31) durch den magnetischen Kern (5) verläuft.

4. Messshunt (1) nach einem der vorhergehenden Ansprüche, wobei der Mittelabschnitt (11) des Widerstandselements (3) U-förmig ausgebildet ist.

5. Messshunt (1) nach einem der vorhergehenden Ansprüche, wobei der magnetische Kern (5) aus zwei aneinandergefügten Kernteilen (25,27) besteht.

6. Messshunt (1) nach einem der vorhergehenden Ansprüche, wobei der magnetische Kern (5) von dem Widerstandselement (3) durch einen Luftspalt (23) beabstandet ist.

7. Messshunt (1) nach einem der Ansprüche 1 bis 4, wobei der magnetische Kern (5) um den Mittelabschnitt (11) des Widerstandselements (3) spritzgegossen ist.

8. Schaltungsanordnung (37) mit wenigstens zwei zueinander parallel geschalteten Halbbrücken (39,41), in deren Brückenarmen jeweils wenigstens ein elektronischer Schalter (43) angeordnet ist, wobei in dem Brückenzweig jeder Halbbrücke (39, 41) ein Messshunt (1) gemäß einem der vorhergehenden Ansprüche angeordnet ist.

9. Stromrichter (51) mit wenigstens einer Schaltungsanordnung (37) gemäß Anspruch 8.
